# DEMANDE DE BREVET EUROPEEN

(11) **EP 1 870 936 A1**
(43) Date de publication de la demande: **26.12.2007**
(21) Numéro de dépôt: 07011431.9
(22) Date de dépôt: 12.06.2007
(51) Int. Cl.: H01L 27/146, G02B 3/00, B29D 11/00

(54) **Procédé de fabrication de lentilles, notamment pour imageur intégré**

(30) Priorité: 19.06.2006 FR 0605476
(71) Demandeur: STMicroelectronics (Rousset) SAS, 13790 Rousset (FR)
(72) Inventeur: Dunne, Brendan, 13120 Gardanne (FR); Ronchi, Robert, 83520 Roquebrune Sur Argens (FR); Gagliano, Olivier, 13013 Marseille (FR); Mionetto, Roberto, 83170 Tourves (FR)
(74) Mandataire: Marchand, André

(57) **Abrégé**

L'invention concerne un procédé de fabrication d'un micromodule de capture d'images comprenant un imageur (11) et au moins une lentille, le procédé comprenant des étapes de fabrication d'au moins un imageur (11) sur une première plaquette (10) en un matériau semi-conducteur, réalisation d'au moins une zone optique (21a, 21b) pour former une lentille dans au moins une seconde plaquette (20a, 20b) en un matériau transparent, et d'assemblage des première et seconde plaquettes de manière que l'imageur puisse recevoir de la lumière au travers de la zone optique.

## Description

La présente invention concerne la fabrication de lentilles optiques pour imageurs intégrés et notamment pour imageurs CMOS.

Les imageurs réalisés selon la technologie CMOS ("Complementary Metal Oxide Semiconductor") font actuellement l'objet d'un nombre croissant d'applications en raison de leur faible prix de revient comparativement aux imageurs CCD (Charge Coupled Device). De tels imageurs CMOS étaient initialement utilisés pour réaliser des capteurs d'image à faible résolution et de qualité médiocre (par exemple des caméras web). Aujourd'hui, après un important investissement en recherche et développement, les imageurs CMOS peuvent rivaliser avec les imageurs CCD. La présente invention s'inscrit dans un effort de perfectionnement de cette technologie d'imageurs visant une baisse des prix de revient à qualité égale.

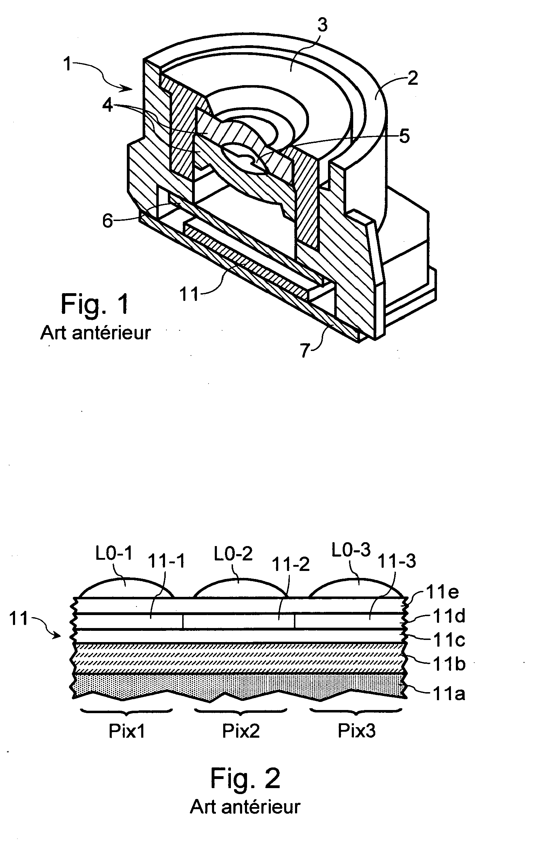

La figure 1 représente un exemple de module de capture d'images et/ou de capture vidéo utilisant un imageur CMOS, destiné par exemple à être monté dans un appareil portatif tel qu'un téléphone mobile, un appareil photographique ou une caméra vidéo. Le module 1 comprend un châssis 2, un bloc optique ou bloc porte-lentilles 3, un objectif à base de lentilles 4 montées dans le bloc 3 avec un diaphragme 5, un filtre infrarouge 6 et un support 7. Un imageur CMOS 11 se présentant sous la forme d'une microplaquette de semi-conducteur est disposé sur le support 7 de manière à recevoir la lumière passant au travers des lentilles 4, du diaphragme 5 et du filtre infrarouge 6.

L'imageur CMOS 11 comprend une pluralité de photosites formant chacun un pixel (non visibles sur la figure 1). Chaque pixel comprend une photodiode et un circuit de contrôle et d'interconnexion de la photodiode. Les pixels sont agencés de façon matricielle et une mosaïque de filtres rouges, verts, bleus est répartie au-dessus de la matrice de pixels, généralement selon l'architecture de Bayer (les cellules d'une ligne étant alternativement rouges et vertes ou alternativement vertes et bleues). Chaque pixel est ainsi recouvert par un filtre de couleur primaire déterminée, rouge, verte ou bleue, et fournit une information de luminance relative à la couleur primaire qui lui est attribuée, formant une information de pixel.

La figure 2 est une vue en coupe schématique de l'imageur CMOS 11 dans une région correspondant à trois pixels PIX1, PIX2, PIX3. En allant du bas vers le haut, on distingue des couches 11a, 11b, 11c, 11d, 11e et des microlentilles L0 (L0-1, L0-2, L0-3). La couche 11a est le substrat semi-conducteur dans lequel l'imageur est implanté. Cette couche 11a représente ainsi la partie active de l'imageur et comprend des photodiodes et leurs circuits de contrôle et d'interconnexion associés (non détaillés). La couche 11b est formée par un matériau diélectrique qui recouvre entièrement le substrat 11a. La couche 11c est une couche de passivation déposée sur l'imageur en fin de processus de fabrication CMOS. La couche 11d est formée par des résines colorées et comprend des secteurs 11-1, 11-2, 11-3 de couleur rouge, verte ou bleue formant les filtres de couleur primaire susmentionnés, à raison d'un filtre de couleur par pixel. La couche 11e est une couche de résine intermédiaire formant un support pour les microlentilles L0 et offrant une bonne planéité. Les microlentilles L0 sont agencées en une matrice dite "MLA" ("Microlens Array") à raison d'une microlentille par pixel.

Les lentilles 4 du bloc optique sont généralement formées dans des moules au moyen d'une résine polymère qui est retirée des moules après une étape de cuisson. Une autre technique connue de fabrication des lentilles 4 consiste en une impression de résine polymère sur un support puis fluage de la résine pour obtenir une face convexe (bombée).

Les microlentilles L0 sont également réalisées au moyen d'une résine polymère et leur procédé de fabrication comprend par exemple des étapes de dépôt d'une couche de résine polymère photosensible (photorésine) sur une plaquette d'imageur, une étape de cuisson douce ("soft bake"), une étape d'exposition de la couche de résine à une lumière ultraviolette à travers un masque d'insolation et une étape de retrait des parties insolées avec un solvant organique pour obtenir une matrice de pastilles plates. Les lentilles plates sont ensuite soumises à une température déterminée pour subir un fluage thermique qui rend convexe leur face supérieure. Une opération finale de recuit permet d'assurer leur durcissement.

Ces procédés de fabrication et notamment le procédé de fabrication et de montage des lentilles d'objectif dans le bloc optique, présentent l'inconvénient d'être complexes, et longs à mettre en oeuvre, et de faire intervenir de nombreuses pièces. Par conséquent, ces procédés sont coûteux.

Un objectif de la présente invention est de prévoir un procédé de fabrication et de montage de lentilles sur un imageur qui constitue une alternative avantageuse aux procédés connus. En particulier, la présente invention a pour but de permettre une fabrication collective de modules de capture d'images ayant une structure simplifiée.

Ainsi, une idée de l'invention est de réaliser collectivement les lentilles dans une plaquette en un matériau transparent et de fixer la plaquette intégrant les lentilles directement sur une plaquette en un matériau semi-conducteur (wafer) sur laquelle ont été réalisés collectivement des imageurs, puis de découper les deux plaquettes fixées l'une à l'autre en microplaquettes pour individualiser les imageurs associés aux lentilles, et ainsi fabriquer collectivement des modules de capture d'images ou de capture vidéo.

Plus précisément, la présente invention prévoit un procédé de fabrication d'un micromodule de capture d'images comprenant un imageur et au moins une lentille, le procédé comprenant une étape de fabrication d'au moins un imageur sur une première plaquette en un matériau semi-conducteur.

Selon un mode de réalisation de l'invention, le procédé comprend des étapes consistant à :
- réaliser au moins une zone optique pour former une lentille dans au moins une seconde plaquette en un matériau transparent, et
- assembler les première et seconde plaquettes de manière que l'imageur puisse recevoir de la lumière au travers de la zone optique.

Selon un mode de réalisation de l'invention, le procédé comprend une étape de réalisation dans la seconde plaquette d'au moins un réseau de diffraction formant un filtre infrarouge, de manière à filtrer la lumière arrivant sur l'imageur au travers de la zone optique.

Selon un mode de réalisation de l'invention, le procédé comprend une étape de réalisation dans la seconde plaquette d'au moins un diaphragme, de manière que la lumière arrivant sur l'imageur au travers de la zone optique passe par le diaphragme.

Selon un mode de réalisation de l'invention, le réseau de diffraction et/ou le diaphragme est réalisé à l'aide d'un faisceau laser focalisé à une profondeur souhaitée dans la seconde plaquette, le faisceau laser présentant une énergie suffisante pour.rendre opaque le matériau constituant la seconde plaquette.

Selon un mode de réalisation de l'invention, les première et seconde plaquettes sont assemblées au moyen d'une couche de colle transparente dont l'épaisseur est suffisante pour empêcher que la seconde plaquette soit directement en contact avec des microlentilles de l'imageur.

Selon un mode de réalisation de l'invention, le procédé comprend des étapes de réalisation d'au moins une zone optique pour former une lentille dans une troisième plaquette en un matériau transparent, et d'assemblage des seconde et troisième plaquettes, de manière que chaque zone optique de la troisième plaquette forme une lentille avec une zone optique de la seconde plaquette.

Selon un mode de réalisation de l'invention, les zones optiques des seconde et troisième plaquettes forment des cavités dans les plaquettes, les seconde et troisièmes plaquettes étant assemblées de manière que chaque zone optique de la seconde plaquette forme avec une zone optique de la troisième plaquette un volume fermé de forme lenticulaire.

Selon un mode de réalisation de l'invention, le volume fermé est rempli d'un matériau transparent ayant un indice de réfraction choisi en fonction des propriétés optiques de la lentille à réaliser.

Selon un mode de réalisation de l'invention, le procédé comprend une étape de réalisation dans la troisième plaquette d'au moins un réseau de diffraction formant un filtre infrarouge, de manière à filtrer la lumière arrivant sur l'imageur au travers de la zone optique formée dans la troisième plaquette.

Selon un mode de réalisation de l'invention, le procédé comprend une étape de réalisation dans la troisième plaquette d'au moins un diaphragme, de manière que la lumière arrivant sur l'imageur au travers de la zone optique passe par le diaphragme.

Selon un mode de réalisation de l'invention, le réseau de diffraction et/ou le diaphragme est réalisé à l'aide d'un faisceau laser focalisé à une profondeur souhaitée dans la troisième plaquette, le faisceau laser présentant une énergie suffisante pour rendre opaque le matériau constituant la troisième plaquette.

Selon un mode de réalisation de l'invention, chaque zone optique comprend une cavité lenticulaire formée dans la seconde plaquette, le procédé comprenant une étape de formation d'une lentille en un matériau transparent dans la cavité lenticulaire.

Selon un mode de réalisation de l'invention, chaque zone optique comprend une première zone bombée formant une lentille sur une face de la plaquette en regard avec l'imageur, et des moyens pour espacer la zone bombée de l'imageur.

Selon un mode de réalisation de l'invention, chaque zone optique comprend sur une face opposée à la face comportant la première zone bombée une seconde zone bombée centrée sur la première zone bombée.

Selon un mode de réalisation de l'invention, la première zone bombée est formée au fond d'une cavité qui est remplie d'un matériau transparent.

L'invention concerne également l'application du procédé tel que défini ci-avant, à la fabrication collective de micromodules de capture d'images, comprenant des étapes consistant à :
- réaliser collectivement une pluralité d'imageurs sur la première plaquette,
- réaliser collectivement une pluralité de zones actives formant des lentilles sur la seconde plaquette, et
- découper les plaquettes après leur assemblage pour obtenir des micromodules individuels.

L'invention concerne également l'application du procédé tel que défini ci-avant, à la fabrication collective de micromodules de capture d'images, comprenant des étapes consistant à :
- réaliser collectivement une pluralité d'imageurs sur la première plaquette,
- découper la plaquette pour obtenir des imageurs individuels,
- réaliser collectivement une pluralité de zones actives formant des lentilles sur la seconde plaquette, et
- assembler des imageurs sur la seconde plaquette de manière que l'imageur puisse recevoir de la lumière au travers d'une zone optique, et
- découper la seconde plaquette après son assemblage avec les imageurs pour obtenir des micromodules individuels.

L'invention concerne également l'application du procédé tel que défini ci-avant, à la fabrication collective de micromodules de capture d'images, comprenant des étapes consistant à :
- réaliser collectivement une pluralité d'imageurs sur la première plaquette,
- réaliser collectivement une pluralité de zones actives formant des lentilles sur la seconde plaquette, et
- découper la plaquette pour obtenir des lentilles individuelles,
- assembler des lentilles sur la première plaquette de manière que les imageurs puissent recevoir de la lumière au travers d'une lentille, et
- découper la première plaquette après son assemblage avec les lentilles pour obtenir des micromodules individuels.

L'invention concerne également un module de capture d'images comprenant un imageur et au moins une lentille, l'imageur étant réalisé sur une première plaquette en un matériau semi-conducteur.

Selon un mode de réalisation de l'invention, la lentille comprend une zone optique réalisée dans au moins une seconde plaquette en un matériau transparent, et les première et seconde plaquettes sont assemblées de manière que l'imageur puisse recevoir de la lumière au travers de la zone optique.

Selon un mode de réalisation de l'invention, le module comprend un réseau de diffraction formant un filtre infrarouge réalisé dans la seconde plaquette de manière à filtrer la lumière arrivant sur l'imageur au travers de la zone optique.

Selon un mode de réalisation de l'invention, le module comprend un diaphragme réalisé dans la seconde plaquette de manière que la lumière arrivant sur l'imageur au travers de la zone optique passe par le diaphragme.

Selon un mode de réalisation de l'invention, le diaphragme est réalisé à l'aide d'un faisceau laser focalisé à une profondeur souhaitée dans la seconde plaquette, le faisceau laser présentant une énergie suffisante pour rendre opaque le matériau constituant la seconde plaquette.

Selon un mode de réalisation de l'invention, les première et seconde plaquettes sont assemblées au moyen d'une couche de colle transparente dont l'épaisseur est suffisante pour empêcher que la seconde plaquette soit directement en contact avec des microlentilles de l'imageur.

Selon un mode de réalisation de l'invention, la lentille comprend une zone optique réalisée dans une troisième plaquette en un matériau transparent, les première et seconde plaquettes étant assemblées l'une à l'autre.

Selon un mode de réalisation de l'invention, les zones optiques des seconde et troisième plaquettes forment des cavités dans les plaquettes, les seconde et troisièmes plaquettes étant assemblées de manière que chaque zone optique de la seconde plaquette forme avec une zone optique de la troisième plaquette un volume fermé de forme lenticulaire.

Selon un mode de réalisation de l'invention, le volume fermé est rempli d'un matériau transparent ayant un indice de réfraction choisi en fonction des propriétés optiques de la lentille à réaliser.

Selon un mode de réalisation de l'invention, la troisième plaquette comprend un réseau de diffraction formant un filtre infrarouge, pour filtrer la lumière arrivant sur l'imageur au travers de la zone optique formée dans la troisième plaquette.

Selon un mode de réalisation de l'invention, la troisième plaquette comprend un diaphragme, pour que la lumière arrivant sur l'imageur au travers de la zone optique passe par le diaphragme.

Selon un mode de réalisation de l'invention, le réseau de diffraction et/ou le diaphragme est réalisé à l'aide d'un faisceau laser focalisé à une profondeur souhaitée dans la troisième plaquette, le faisceau laser présentant une énergie suffisante pour rendre opaque le matériau constituant la troisième plaquette.

Selon un mode de réalisation de l'invention, la zone optique comprend une cavité lenticulaire formée dans la seconde plaquette et une lentille en un matériau transparent formée dans la cavité lenticulaire.

Selon un mode de réalisation de l'invention, la zone optique comprend une première zone bombée formant une lentille sur une face de la plaquette en regard avec l'imageur, et des moyens pour espacer la zone bombée de l'imageur.

Selon un mode de réalisation de l'invention, chaque zone optique comprend sur une face opposée à la face comportant les premières zones bombées une seconde zone bombée centrée sur la première zone bombée.

Selon un mode de réalisation de l'invention, la première zone bombée est formée au fond d'une cavité qui est remplie d'un matériau transparent.

Ces objets, caractéristiques et avantages ainsi que d'autres de la présente invention seront exposés plus en détail dans la description suivante d'un mode de réalisation de l'invention, faite à titre non limitatif en relation avec les figures jointes parmi lesquelles :
- la figure 1 précédemment décrite représente un bloc d'imageur CMOS selon l'art antérieur,
- la figure 2 précédemment décrite est une vue en coupe d'une microplaquette d'imageur CMOS,
- la figure 3 est une vue de dessus d'un wafer de semi-conducteur sur lequel ont été réalisés collectivement des imageurs,
- la figure 4 est une vue de dessus d'une plaquette dans laquelle ont été réalisées collectivement des lentilles,
- la figure 5 est une vue en coupe partielle de la plaquette de lentille représentée sur la figure 4,
- la figure 6 est une vue en coupe partielle d'un wafer d'imageurs sur lequel ont été assemblées des plaquettes de lentilles, selon un premier mode de réalisation de l'invention,
- la figure 7 est une vue en coupe partielle d'un assemblage de deux plaquettes de lentille, selon un second mode de réalisation de l'invention,
- la figure 8 est une vue en coupe partielle d'une plaquette de lentille, selon un troisième mode de réalisation de l'invention,
- les figures 9A à 9D sont des vues en coupe partielle d'une plaquette de lentille selon un quatrième mode de réalisation, illustrant des étapes de fabrication de la plaquette de lentille,
- la figure 10 est une vue en coupe partielle d'une plaquette de lentille, selon un cinquième mode de réalisation de l'invention, assemblée sur un wafer d'imageurs,
- la figure 11 est une vue en coupe partielle d'une plaquette de lentille, selon un sixième mode de réalisation de l'invention, assemblée sur un wafer d'imageurs.

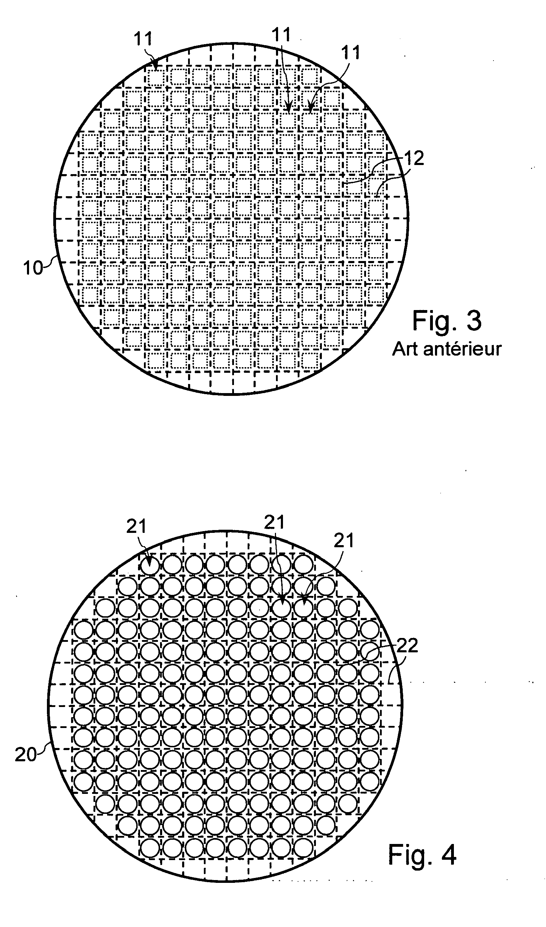

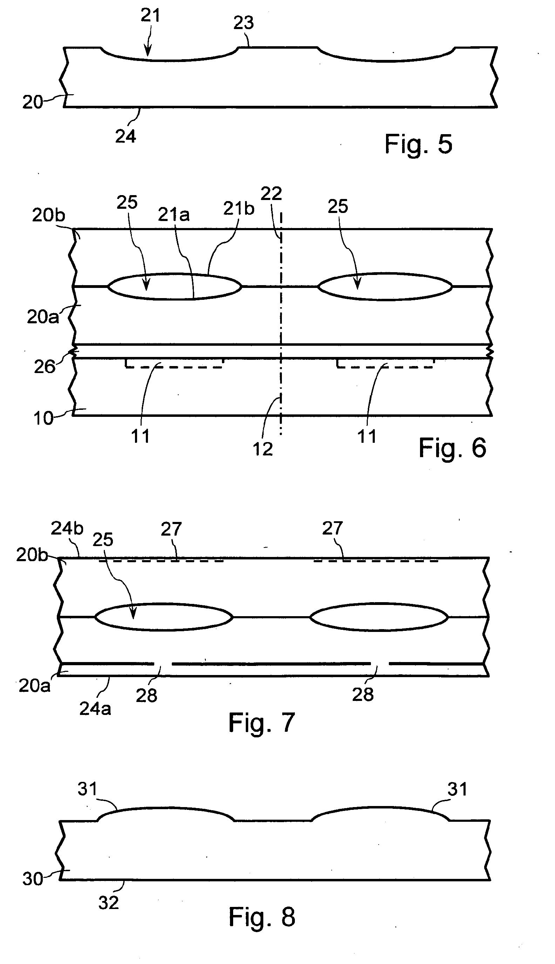

Selon un mode de réalisation de l'invention, la fabrication de modules de capture d'images ou de capture vidéo comprend les étapes suivantes :
- une étape de réalisation collective d'imageurs CMOS sur une première plaquette de silicium 10 ("wafer"), illustrée sur les figures 2 et 3,
- une étape de réalisation collective de lentilles sur une seconde plaquette en un matériau transparent 20, illustrée sur les figures 4 à 7,
- une étape d'assemblage des plaquettes 10, 20, illustrée sur la figure 6, et
- une étape de découpe des plaquettes 10, 20 après assemblage (non représentée), permettant d'obtenir des micromodules individuels pré-assemblés comprenant chacun un imageur CMOS 11 et une lentille.

La figure 3 est une vue de la face avant d'un wafer de semi-conducteur 10 classique, généralement en silicium, comprenant une pluralité de régions actives 11 formant chacune un imageur tel que celui représenté sur la figure 2. Les régions actives 11 ont été réalisées collectivement sur le wafer en utilisant les techniques de la microélectronique, notamment par implantation de dopants, dépôt et/ou croissance d'oxyde et dépôt et/ou croissance de divers matériaux (métal, polysilicium, matériau diélectrique, matériau de passivation, résines colorées, résine polymère, ...).

Après réalisation des régions actives 11, le wafer doit normalement être découpé en microplaquettes comprenant chacune l'une de ces régions actives. Cette opération de découpe du wafer en "dés", appelée "singulation", est généralement réalisée avec une scie diamantée, en suivant des chemins de découpe 12 représentés en traits pointillés sur la figure 3 et formant un quadrillage à la surface du wafer.

Selon un mode de réalisation de l'invention, les lentilles sont également réalisées collectivement sur une plaquette représentée en vue de face avant ou arrière sur la figure 4. La plaquette 20 représentée sur la figure 4 comprend des zones optiques 21 de forme circulaire, formant chacune une lentille ou une partie de lentille. Les zones optiques 21 sont arrangées sur la plaquette sous forme matricielle (en lignes et en colonnes) avec un pas identique à celui des imageurs CMOS 11 sur le wafer 10 représenté sur la figure 3. De cette manière, il est possible de centrer chaque zone optique 21 sur un imageur 11, lorsque la plaquette 20 est disposée sur le wafer 10.

La figure 5 représente en coupe partielle une plaquette 20 selon un premier mode de réalisation de l'invention. Sur la figure 5, la plaquette 20 comporte une face plane 24 et une face opposée 25 comprenant des zones optiques 21 de forme concave, par exemple sphérique.

La plaquette 20 est par exemple formée dans un moule au moyen d'une résine polymère transparente qui est retirée du moule après une étape de cuisson.

La figure 6 représente un premier mode de réalisation de lentilles selon l'invention. Sur la figure 6, les lentilles sont réalisées à l'aide de deux plaquettes 20a, 20b, telles que celle représentée sur les figures 4 et 5. Les deux plaquettes 20a, 20b sont assemblées l'une contre l'autre, chaque zone optique 21a de la plaquette 20a est disposée en regard d'une zone optique 21b de la plaquette 20b, de manière à délimiter ensemble une cavité de forme lenticulaire 25. Les deux plaquettes 20a, 20b sont fixées l'une à l'autre par un moyen approprié, tel qu'une colle transparente.

Le rayon de courbure de chaque zone optique 21a est identique ou différent de celui des zones optiques 21b. Les rayons de courbure des zones 21a, 21b sont choisis en fonction des propriétés optiques souhaitées des lentilles à réaliser.

Chacune des deux plaquettes 20a, 20b présente un indice de réfraction également choisi en fonction des propriétés optiques souhaitées des lentilles à réaliser.

Préalablement à la fixation des plaquettes 20a, 20b, les cavités 25 peuvent être remplies d'un matériau transparent ayant un indice de réfraction choisi en fonction des propriétés optiques souhaitées des lentilles à réaliser.

Une fois assemblées, les plaquettes 20a, 20b sont fixées sur le wafer 10 à l'aide d'une couche de colle transparente 26. L'épaisseur de la couche de colle est suffisante pour éviter que la plaquette 20a soit en contact avec les microlentilles LO formées sur le wafer 10. La couche de colle 26 est par exemple déposée sous forme liquide tandis que le wafer 10 est mis en rotation autour de son axe de symétrie de révolution, pour obtenir une couche de colle répartie uniformément.

Alternativement, la face avant du wafer peut être préalablement protégée par une couche en un matériau transparent. Dans ce cas, il n'est pas nécessaire que la couche de colle soit épaisse.

Il est à noter que la plaquette 20a peut être assemblée au wafer 10 avant d'être assemblée à la plaquette 20b.

A l'étape de fabrication suivante, l'ensemble du wafer 10 et des plaquettes 20a, 20b fixées sur le wafer est découpé en microplaquettes comprenant chacune l'une des régions actives 11 du wafer et une lentille 21a, 21b fixée sur la région active 11. Cette opération de découpe en "dés", appelée "singulation", peut être réalisée avec une scie diamantée, en suivant des chemins de découpe 12, 22 (représentés en traits pointillés sur les figures 3 et 4), formant un quadrillage à la surface du wafer 10 et à la surface des plaquettes 20a, 20b.

Sur la figure 7 représentant les plaquettes 20a, 20b assemblées, la plaquette 20a comprend un filtre infrarouge 27 formé sur la face plane 24a en regard de chaque zone 21a, 21b. Chaque filtre infrarouge est réalisé par un réseau de diffraction dont la géométrie est déterminée en fonction de la plage de longueurs d'ondes à filtrer. Chaque réseau de diffraction est réalisé par exemple en formant des réseaux de tranchées dans le moule de fabrication de la plaquette 20 sur la face plane 24. Après démoulage, la face plane est recouverte d'une couche d'un matériau opaque approprié qui remplit également les tranchées. La face recouverte du matériau opaque est ensuite polie pour faire apparaître les tranchées remplies du matériau opaque et la face plane entre les tranchées.

Les réseaux de diffraction peuvent également être réalisés dans la masse de la plaquette 20a ou 20b à l'aide d'un faisceau laser focalisé au travers d'une lentille "grand angle" à une profondeur souhaitée dans la plaquette. Le faisceau laser utilisé présente une énergie suffisante pour dégrader localement le matériau constituant la plaquette en le rendant opaque, mais sans altérer le reste du matériau, que ce soit en surface ou dans le reste du volume. A cet effet, Le faisceau laser utilisé est par exemple un faisceau laser femtoseconde. Le motif du réseau de diffraction est réalisé par exemple en déplaçant la plaquette dans son plan.

A noter que les réseaux de diffraction peuvent être formés indifféremment dans l'une et/ou l'autre des deux plaquettes 20a, 20b.

On peut également réaliser dans l'une ou l'autre des deux plaquettes 20a, 20b un diaphragme 28 en regard de chaque zone optique 21a, 21b. Le diaphragme est avantageusement réalisé à l'aide de la technique décrite précédemment faisant intervenir un faisceau laser d'énergie suffisante focalisé à une certaine profondeur dans la plaquette.

La figure 8 représente un troisième mode de réalisation de lentilles selon l'invention. Sur la figure 8, les lentilles sont formées à l'aide d'une plaquette 30 comportant une face plane 32 et une face opposée comportant des zones bombées 31 formant chacune une lentille. La plaquette 30 peut être réalisée par moulage.

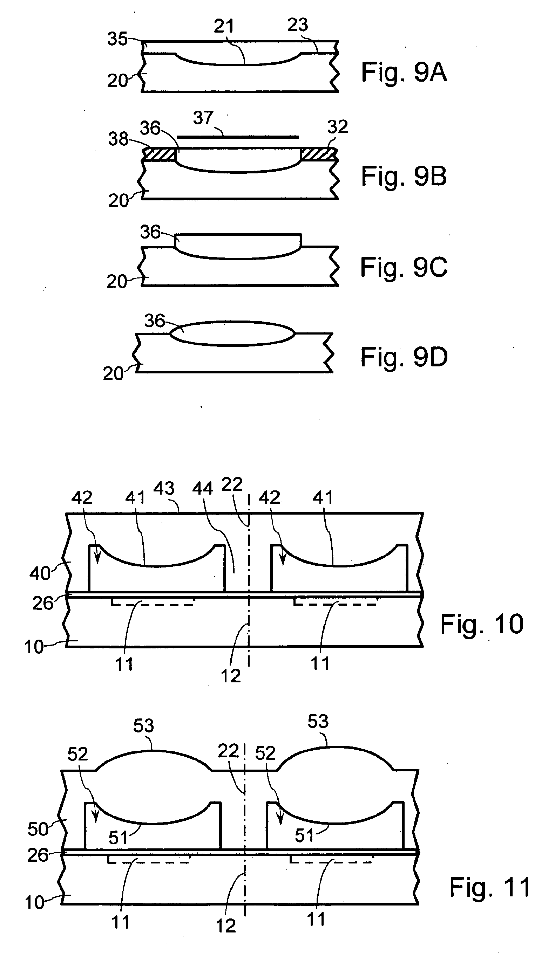

Les figures 9A à 9D représentent un troisième mode de réalisation de lentilles selon l'invention. Sur la figure 9D, les lentilles sont formées à l'aide d'une plaquette 20 telle que celle représentée sur les figures 4 et 5. Des lentilles 36 sont formées dans les cavités 21.

Les lentilles 36 sont formées de la manière illustrée par les figures 9A à 9D. Sur la figure 9A, la face 23 comportant les cavités 21 de la plaquette 20 est recouverte d'une couche 35 en une résine polymère transparente photosensible, déposée sous forme liquide qui subit une étape de cuisson.

Sur la figure 9B, la couche de résine 35 est exposée à une lumière ultraviolette au travers d'un masque d'insolation 37 protégeant les zones de la couche 35 au dessus des zones 21.

Sur la figure 9C, les zones 38 qui ont été exposées à la lumière ultraviolette sont retirées, par exemple à l'aide d'un solvant organique pour obtenir une matrice de pastilles plates 36 formées au dessus des zones 21.

Sur la figure 9D, les pastilles plates 36 restantes de la couche 35 sont soumises à une température déterminée pour subir un fluage thermique qui rend la face plate des pastilles convexe (bombée). Une opération finale de recuit permet d'assurer leur durcissement.

La figure 10 représente un troisième mode de réalisation de lentilles selon l'invention. La figure 10 représente une plaquette 40 comportant une face plane 43 et une face opposée comprenant des cavités 42 de forme cylindrique ou cubique, ou plus généralement parallélépipédique. Les cavités 42 présentent un fond bombé 41 et sont agencées de manière à ce que leur fond bombé 41 puisse être centré au dessus d'une zone active 11 du wafer.

Les fonds bombés 41 sont de préférence de forme sphériques dont le rayon de courbure est choisi en fonction des propriétés optiques souhaitées des lentilles.

La plaquette 40 est avantageusement fabriquée par moulage d'une résine polymère transparente.

Les cavités 42 sont soit laissées vides, soit remplies partiellement ou totalement d'une résine polymère transparente présentant un indice de réfraction choisi en fonction des propriétés optiques souhaitées des lentilles à réaliser.

Comme précédemment décrit en référence à la figure 7, des réseaux de diffraction réalisant des filtres infrarouges ou des diaphragmes peuvent être formés sur les faces planes ou dans la plaquette.

Dans une variante de réalisation, la plaquette 40 ne comporte pas de cavités, mais simplement des zones bombées 41 et des entretoises 44 espaçant les parties bombées 41 de la face avant du wafer 10.

La figure 11 représente une autre variante de la plaquette représentée sur la figure 10. La plaquette 50 représentée sur la figure 11 présente une forme analogue à celle de la plaquette 40, à la seule différence qu'elle ne comporte pas de face plane supérieure 43. Ainsi, la plaquette 50 présente une face comportant des cavités 52 de forme cylindrique ou cubique, ou plus généralement parallélépipédique, avec un fond bombé 51. La face 53 opposée à celle comportant les cavités 52 présente également des zones bombées 53 centrées sur les fonds bombés 51.

Les cavités 42, 52 sont soit laissées vides, soit remplies partiellement ou totalement d'une résine polymère transparente présentant un indice de réfraction choisi en fonction des propriétés optiques souhaitées des lentilles à réaliser.

Sur les figures 10 et 11, il n'est pas nécessaire de prévoir une couche de colle 26 épaisse pour fixer la plaquette 40, 50 sur le wafer 10, puisque la présence des cavités 42, 52 évite tout contact entre la plaquette 40, 50 et les microlentilles formées sur l'imageur 11.

Ainsi, les diverses étapes de fabrication décrites dans ce qui précède, notamment de fabrication des plaquettes de lentilles, de montage, d'assemblage, et de découpage ne nécessitent que la mise en oeuvre de techniques couramment employées dans l'industrie de la microélectronique. Le module de capture d'images est ainsi obtenu collectivement à partir d'une plaquette de silicium comportant les imageurs avec leurs filtres colorés et leur microlentilles, et d'une ou plusieurs plaquettes en matériaux transparents, formant les lentilles d'objectif, éventuellement associées chacune à un filtre infrarouge ou ultraviolet et un diaphragme.

L'invention permet ainsi des cadences de fabrication bien plus élevées que celles faisant intervenir un bloc porte-lentilles dans lequel doivent être montées les lentilles d'objectif et un diaphragme, le bloc porte-lentilles devant ensuite être monté séparément dans un châssis avec l'imageur et le filtre infrarouge. A la suite de la phase de découpage des plaquettes assemblées, les modules ainsi individualisés sont constitués chacun d'une pièce unique. Ils peuvent ainsi être montés en une seule manipulation dans un châssis. Comme le châssis ne doit recevoir qu'une seule pièce, sa structure peut être simplifiée d'une manière importante, ce qui en réduit d'autant le coût de fabrication.

Il apparaîtra clairement à l'homme de l'art que la présente invention est susceptible de diverses variantes de réalisation. En particulier, le procédé de fabrication selon l'invention est susceptible d'autres modes de réalisation, notamment en ce qui concerne l'ordre de mise en oeuvre des étapes de découpe et d'assemblage des plaquettes 10, 20.

Ainsi, dans un second mode de réalisation, la plaquette 10 est préalablement découpée suivant ses chemins de découpe 12 pour obtenir une pluralité de microplaquettes comportant chacune un imageur. Chaque imageur CMOS est ensuite assemblé sur la plaquette 20.

Dans un troisième mode de réalisation, c'est la plaquette 20, 40, 50 ou les plaquettes 20a, 20b une fois assemblées qui sont préalablement découpées suivant leurs chemins de découpe 22 pour obtenir une pluralité de microplaquettes comportant chacune une ou plusieurs lentilles d'objectif. Chaque microplaquette est ensuite assemblée sur la plaquette 10.

Ces modes de réalisation autorisent notamment une différence de dimensions entre les imageurs et les microplaquettes formant les lentilles d'objectif. Si la région la plus petite est découpée avant l'étape d'assemblage, elle peut être réalisée en plus grand nombre sur une même plaquette que l'autre région. La surface des deux plaquettes peut ainsi être utilisée au maximum. Ainsi, l'imageur peut avoir une surface plus grande que sa surface optiquement sensible, de manière à intégrer des fonctions plus évoluées de traitement de signaux d'image.

Il apparaîtra également à l'homme de l'art que le procédé selon l'invention est susceptible de divers autres modes de réalisation. Les exemples de plaquettes de lentilles décrites laissent entrevoir de nombreux autres modes de réalisation de lentilles. Il est envisageable par exemple d'assembler plus de deux plaquettes transparentes pour obtenir une combinaison de lentilles plus complexe. Ainsi, il est envisageable d'assembler une plaquette 20b telle que représentée sur la figure 6 avec une plaquette 50. Sur la figure 8, il est envisageable de former sur la plaquette 20 une couche 30 plus épaisse reliant entre elles les formes lenticulaires 31. Cette couche plus épaisse peut être réalisée séparément par moulage. La face supérieure de cette couche plus épaisse peut également recevoir une plaquette 20b.

Il apparaîtra également clairement à l'homme de l'art que la présente invention est susceptible de diverses applications. Ainsi, la présente invention ne s'applique pas uniquement aux imageurs CMOS, mais plus généralement à tout imageur constitué d'un circuit intégré, tel que les imageurs CCD.

## Revendications

1. Procédé de fabrication d'un micromodule de capture d'images comprenant un imageur (11) et au moins une lentille, le procédé comprenant une étape de fabrication d'au moins un imageur (11) sur une première plaquette (10) en un matériau semi-conducteur,
**caractérisé en ce qu'**il comprend des étapes consistant à :
- réaliser au moins une zone optique (21, 21a, 31, 36, 41, 51) pour former une lentille dans au moins une seconde plaquette (20, 20a, 20b, 30, 40, 50) en un matériau transparent, et
- assembler les première et seconde plaquettes de manière que l'imageur puisse recevoir de la lumière au travers de la zone optique.

2. Procédé selon la revendication 1, comprenant une étape de réalisation dans la seconde plaquette (20, 20a, 40, 50) d'au moins un réseau de diffraction (27) formant un filtre infrarouge, de manière à filtrer la lumière arrivant sur l'imageur (11) au travers de la zone optique (21, 21a, 31, 41, 51).

3. Procédé selon la revendication 1 ou 2, comprenant une étape de réalisation dans la seconde plaquette (20, 20a, 40, 50) d'au moins un diaphragme (28), de manière que la lumière arrivant sur l'imageur (11) au travers de la zone optique (21, 21a, 41, 51) passe par le diaphragme.

4. Procédé selon la revendication 2 ou 3, dans lequel le réseau de diffraction et/ou le diaphragme (28) est réalisé à l'aide d'un faisceau laser focalisé à une profondeur souhaitée dans la seconde plaquette (20, 20a, 40, 50), le faisceau laser présentant une énergie suffisante pour rendre opaque le matériau constituant la seconde plaquette.

5. Procédé selon l'une des revendications 1 à 4, dans lequel les première et seconde plaquettes (10, 20, 20a, 40, 50) sont assemblées au moyen d'une couche de colle transparente (26) dont l'épaisseur est suffisante pour empêcher que la seconde plaquette soit directement en contact avec des microlentilles (LO) de l'imageur (11).

6. Procédé selon l'une des revendications 1 à 5, comprenant des étapes de réalisation d'au moins une zone optique (21b) pour former une lentille dans une troisième plaquette (20b) en un matériau transparent, et d'assemblage des seconde et troisième plaquettes (20a, 20b), de manière que chaque zone optique (21b) de la troisième plaquette forme une lentille avec une zone optique (21a) de la seconde plaquette.

7. Procédé selon la revendication 6, dans lequel les zones optiques (21a, 21b) des seconde et troisième plaquettes (20a, 20b) forment des cavités dans les plaquettes, les seconde et troisièmes plaquettes étant assemblées de manière que chaque zone optique de la seconde plaquette forme avec une zone optique de la troisième plaquette un volume fermé (25) de forme lenticulaire.

8. Procédé selon la revendication 7, dans lequel le volume fermé (25) est rempli d'un matériau transparent ayant un indice de réfraction choisi en fonction des propriétés optiques de la lentille à réaliser.

9. Procédé selon l'une des revendications 6 à 8, comprenant une étape de réalisation dans la troisième plaquette (20b) d'au moins un réseau de diffraction (27) formant un filtre infrarouge, de manière à filtrer la lumière arrivant sur l'imageur (11) au travers de la zone optique (21b) formée dans la troisième plaquette.

10. Procédé selon l'une des revendications 6 à 9, comprenant une étape de réalisation dans la troisième plaquette (20b) d'au moins un diaphragme (28), de manière que la lumière arrivant sur l'imageur (11) au travers de la zone optique (21b) passe par le diaphragme.

11. Procédé selon la revendication 9 ou 10, dans lequel le réseau de diffraction et/ou le diaphragme (28) est réalisé à l'aide d'un faisceau laser focalisé à une profondeur souhaitée dans la troisième plaquette (20, 20a, 40, 50), le faisceau laser présentant une énergie suffisante pour rendre opaque le matériau constituant la troisième plaquette.

12. Procédé selon l'une des revendications 1 à 5, dans lequel chaque zone optique comprend une cavité lenticulaire (21) formée dans la seconde plaquette (20), le procédé comprenant une étape de formation d'une lentille (31) en un matériau transparent dans la cavité lenticulaire.

13. Procédé selon l'une des revendications 1 à 5, dans lequel chaque zone optique comprend une première zone bombée (41, 51) formant une lentille sur une face de la plaquette (40, 50) en regard avec l'imageur (11), et des moyens pour espacer la zone bombée de l'imageur.

14. Procédé selon la revendication 13, dans lequel chaque zone optique comprend sur une face opposée à la face comportant la première zone bombée (51) une seconde zone bombée (53) centrée sur la première zone bombée.

15. Procédé selon l'une des revendications 13 et 14, dans lequel la première zone bombée (41, 51) est formée au fond d'une cavité (42, 52) qui est remplie d'un matériau transparent.

16. Procédé selon l'une des revendications 1 à 15, pour la fabrication collective de micromodules de capture d'images, comprenant des étapes consistant à :
- réaliser collectivement une pluralité d'imageurs (11) sur la première plaquette (10),
- réaliser collectivement une pluralité de zones actives (21) formant des lentilles sur la seconde plaquette (20), et
- découper les plaquettes (10, 20) après leur assemblage pour obtenir des micromodules individuels.

17. Procédé selon l'une des revendications 1 à 15, pour la fabrication collective de micromodules de capture d'images, comprenant des étapes consistant à :
- réaliser collectivement une pluralité d'imageurs (11) sur la première plaquette (10),
- découper la plaquette (10) pour obtenir des imageurs individuels,
- réaliser collectivement une pluralité de zones actives (21) formant des lentilles sur la seconde plaquette (20), et
- assembler des imageurs (11) sur la seconde plaquette (20, 20a, 20b, 40, 50) de manière que l'imageur puisse recevoir de la lumière au travers d'une zone optique (21, 21a, 21b, 31, 41, 51), et
- découper la seconde plaquette (20) après son assemblage avec les imageurs pour obtenir des micromodules individuels.

18. Procédé selon l'une des revendications 1 à 15, pour la fabrication collective de micromodules de capture d'images, comprenant des étapes consistant à :
- réaliser collectivement une pluralité d'imageurs (11) sur la première plaquette (10),
- réaliser collectivement une pluralité de zones actives (21) formant des lentilles sur la seconde plaquette (20), et
- découper la plaquette (20) pour obtenir des lentilles individuelles,
- assembler des lentilles sur la première plaquette (10) de manière que les imageurs puissent recevoir de la lumière au travers d'une lentille (21, 21a, 21b, 31, 41, 51), et
- découper la première plaquette (20) après son assemblage avec les lentilles pour obtenir des micromodules individuels.

19. Module de capture d'images comprenant un imageur (11) et au moins une lentille, l'imageur étant réalisé sur une première plaquette (10) en un matériau semi-conducteur,
**caractérisé en ce que** :
- la lentille comprend une zone optique (21, 21a, 21b, 31, 36, 41, 51) réalisée dans au moins une seconde plaquette (20, 20a, 20b, 30, 40, 50) en un matériau transparent, et
- les première et seconde plaquettes sont assemblées de manière que l'imageur puisse recevoir de la lumière au travers de la zone optique.

20. Module selon la revendication 19, comprenant un réseau de diffraction (27) formant un filtre infrarouge réalisé dans la seconde plaquette (20, 20a, 20b, 30, 40, 50) de manière à filtrer la lumière arrivant sur l'imageur (11) au travers de la zone optique (21, 21a, 31, 41, 51).

21. Module selon la revendication 19 ou 20, comprenant un diaphragme (28) réalisé dans la seconde plaquette (20, 20a, 40, 50) de manière que la lumière arrivant sur l'imageur (11) au travers de la zone optique (21, 21a, 41, 51) passe par le diaphragme.

22. Module selon la revendication 21, dans lequel le diaphragme (28) est réalisé à l'aide d'un faisceau laser focalisé à une profondeur souhaitée dans la seconde plaquette (20, 20a, 40, 50), le faisceau laser présentant une énergie suffisante pour rendre opaque le matériau constituant la seconde plaquette.

23. Module selon l'une des revendications 19 à 22, dans lequel les première et seconde plaquettes (10, 20, 20a, 40, 50) sont assemblées au moyen d'une couche de colle transparente (26) dont l'épaisseur est suffisante pour empêcher que la seconde plaquette soit directement en contact avec des microlentilles (LO) de l'imageur (11).

24. Module selon l'une des revendications 19 à 23,
dans lequel la lentille comprend une zone optique (21b) réalisée dans une troisième plaquette (20b) en un matériau transparent, les première et seconde plaquettes étant assemblées l'une à l'autre.

25. Module selon la revendication 24, dans lequel les zones optiques (21a, 21b) des seconde et troisième plaquettes (20a, 20b) forment des cavités dans les plaquettes, les seconde et troisièmes plaquettes étant assemblées de manière que chaque zone optique de la seconde plaquette forme avec une zone optique de la troisième plaquette un volume fermé (25) de forme lenticulaire.

26. Module selon la revendication 25, dans lequel le volume fermé (25) est rempli d'un matériau transparent ayant un indice de réfraction choisi en fonction des propriétés optiques de la lentille à réaliser.

27. Module selon l'une des revendications 24 à 26, dans lequel la troisième plaquette (20b) comprend un réseau de diffraction (27) formant un filtre infrarouge, pour filtrer la lumière arrivant sur l'imageur (11) au travers de la zone optique (21b) formée dans la troisième plaquette.

28. Module selon l'une des revendications 24 à 27, dans lequel la troisième plaquette (20b) comprend un diaphragme (28), pour que la lumière arrivant sur l'imageur (11) au travers de la zone optique (21b) passe par le diaphragme.

29. Module selon l'une des revendications 27 et 28, dans lequel le réseau de diffraction et/ou le diaphragme (28) est réalisé à l'aide d'un faisceau laser focalisé à une profondeur souhaitée dans la troisième plaquette (20, 20a, 40, 50), le faisceau laser présentant une énergie suffisante pour rendre opaque le matériau constituant la troisième plaquette.

30. Module selon l'une des revendications 19 à 23, dans lequel la zone optique comprend une cavité lenticulaire (21) formée dans la seconde plaquette (20) et une lentille (31) en un matériau transparent formée dans la cavité lenticulaire.

31. Module selon l'une des revendications 19 à 23, dans lequel la zone optique comprend une première zone bombée (41, 51) formant une lentille sur une face de la plaquette (40, 50) en regard avec l'imageur (11), et des moyens pour espacer la zone bombée de l'imageur.

32. Module selon la revendication 31, dans lequel chaque zone optique comprend sur une face opposée à la face comportant les premières zones bombées (51) une seconde zone bombée (53) centrée sur la première zone bombée.

33. Module selon l'une des revendications 31 et 32, dans lequel la première zone bombée (41, 51) est formée au fond d'une cavité (42, 52) qui est remplie d'un matériau transparent.
